# EUROPÄISCHE PATENTSCHRIFT

(11) **EP 2 631 215 B1**
(45) Veröffentlichungstag und Bekanntmachung des Hinweises auf die Patenterteilung: **26.11.2014**
(21) Anmeldenummer: 13154909.9
(22) Anmeldetag: 12.02.2013
(51) Int. Cl.: C01B 33/02, C01B 33/037, C30B 11/00, C30B 13/00, C30B 15/00, C30B 29/06, H01L 21/02

(54) **Polykristallines Siliciumbruchstück und Verfahren zur Reinigung von polykristallinen Siliciumbruchstücken**
Chunk polycrystalline silicon and process for cleaning polycrystalline silicon chunks
Morceaux de silicium polycristallin et procédé de nettoyage de morceaux de silicium polycristallin

(30) Priorität: 21.02.2012 DE 102012202640
(43) Veröffentlichungstag der Anmeldung: 28.08.2013
(73) Patentinhaber: Wacker Chemie AG, 81737 München (DE)
(72) Erfinder: Traunspurger, Gerhard, 83471 Berchtesgaden (DE); Fabry, Laszlo, Dr., 84489 Burghausen (DE); Pech, Reiner, Dr., 84524 Neuötting (DE)
(74) Vertreter: Killinger, Andreas

(56) Entgegenhaltungen:
- EP-A1- 2 426 085
- US-A- 5 445 679
- DATABASE WPI Week 200011 Thomson Scientific, London, GB; AN 2000-119475 XP002698146, & JP H11 335197 A (NIPPON STEEL CORP) 7. Dezember 1999 (1999-12-07)
- DATABASE WPI Week 200909 Thomson Scientific, London, GB; AN 2009-E34524 XP002698147, & JP 2009 018967 A (SHARP KK) 29. Januar 2009 (2009-01-29)

## Beschreibung

Gegenstand der Erfindung ist ein polykristallines Siliciumbruchstück sowie ein Verfahren zur Reinigung von polykristallinen Siliciumbruchstücken.

Polykristallines Silicium dient als Ausgangsmaterial bei der Herstellung von einkristallinem Silicium mittels Tiegelziehen (Czochralski- oder CZ-Verfahren)-oder mittels Zonenschmelzen (Floatzone oder FZ-Verfahren).

Insbesondere wird aber polykristallines Silicium zur Herstellung von ein- oder multikristallinem Silicium mittels Zieh- oder Gieß-Verfahren benötigt, wobei dieses ein- oder multikristalline Silicium zur Fertigung von Solarzellen für die Photovoltaik dient.

Im industriellen Maßstab wird Rohsilicium durch die Reduktion von Siliciumdioxid mit Kohlenstoff im Lichtbogenofen bei Temperaturen von etwa 2000 °C gewonnen.

Dabei erhält man sog. metallurgisches Silicium (Si_{mg}, "metallurgical grade") mit einer Reinheit von etwa 98-99 %.

Für Anwendungen in der Photovoltaik und in der Mikroelektronik muss das metallurgische Silicium gereinigt werden.
Dazu wird es beispielsweise mit gasförmigem Chlorwasserstoff bei 300-350 °C in einem Wirbelschichtreaktor zu einem Silicium enthaltenden Gas, beispielsweise Trichlorsilan, umgesetzt. Darauf folgen Destillationsschritte, um das Silicium enthaltende Gas zu reinigen.

Dieses hochreines Silicium enthaltende Gas dient dann als Ausgangsstoff für die Herstellung von hochreinem polykristallinem Silicium.

Das polykristalline Silicium, oft auch kurz Polysilicium genannt, wird üblicherweise mittels des Siemens-Prozesses hergestellt. Dabei werden in einem glockenförmigen Reaktor ("Siemens-Reaktor") dünne Filamentstäbe aus Silicium durch direkten Stromdurchgang erhitzt und ein Reaktionsgas enthaltend eine Silicium enthaltende Komponente und Wasserstoff wird eingeleitet.

Beim Siemens-Prozess stecken die Filamentstäbe üblicherweise senkrecht in am Reaktorboden befindlichen Elektroden, über die der Anschluss an die Stromversorgung erfolgt. Je zwei Filamentstäbe sind über eine waagrechte Brücke (ebenfalls aus Silicium) gekoppelt und bilden einen Trägerkörper für die Siliciumabscheidung. Durch die Brückenkopplung wird die typische U-Form der auch Dünnstäbe genannten Trägerkörper erzeugt.

An den erhitzten Stäben und der Brücke scheidet sich hochreines Polysilicium ab, wodurch der Stabdurchmesser mit der Zeit anwächst (CVD / Gasphasenabscheidung).

Nach Beendigung der Abscheidung werden diese Polysiliciumstäbe üblicherweise mittels mechanischer Bearbeitung zu Bruchstücken unterschiedlicher Größenklassen weiterverarbeitet, klassifiziert, gegebenenfalls einer nasschemischen Reinigung unterzogen und schließlich verpackt.

Die Silicium enthaltende Komponente des bei der Abscheidung von polykristallinem Silicium verwendeten Reaktionsgases ist in der Regel Monosilan oder ein Halogensilan der allgemeinen Zusammensetzung SiHₙX₄₋ₙ (n=0, 1, 2, 3; X = Cl, Br, I). Beim Halogensilan kann es sich um ein Chlorsilan, beispielsweise Trichlorsilan handeln. Überwiegend wird SiH₄ oder SiHCl₃ (Trichlorsilan, TCS) im Gemisch mit Wasserstoff eingesetzt.

Die in der Silicium enthaltenden Komponente des Reaktionsgases enthaltenen kohlenstoffhaltigen Verunreinigungen führen zu einer geringfügigen, aber kritisch qualitätsmindernden Kohlenstoffkontamination des daraus abgeschiedenen Siliciums.

Diese Kohlenstoffkontamination im Silicium-Bulk beträgt üblicherweise bis zu 50 ppba.

Die Prozesse der mechanischen Bearbeitung, bis hin zur Verpackung des Polysiliciums, verlaufen größtenteils vollautomatisch. Hierbei kommt es zu Kontaminationen der Oberfläche der Siliciumpartikel mit verschiedenen Metallen aus den Mahl- und Brechwerkzeugen aber auch mit organischen Molekülen und organischen Makromolekülen (Organik).

Ursächlich für die Kontamination des polykristallinen Siliciums mit Organik ist der nicht gänzlich vermeidbare Kontakt des Siliciums mit Bauteilen aus einem organischen Polymer bzw. Kunststoff während der mechanischen Prozesse.

Diese Oberflächenkontamination mit Kohlenstoffverbindungen liegt um ein Vielfaches höher als die zuvor beschriebene Kohlenstoffkontamination während der Gasphasenabscheidung.

Diese oberflächige Kontamination des Polysiliciums mit Organik führt beim Kunden und seinen Prozessen, beispielsweise bei der Herstellung von polykristallinen Solarzellen, zu negativen Auswirkungen:

Bei der Herstellung von polykristallinen Solarzellen, beispielsweise im Blockgießverfahren, wird während des Schmelz-und Abkühlvorganges des Siliciums ein Teil des organischen Kohlenstoffes in Form von Siliciumcarbid-Präzipitaten in den polykristallinen Siliciumblock eingebaut. Diese Einschlüsse führen zu negativen Auswirkungen beim Sägen der Platten durch häufigeren Drahtbruch an der Drahtsäge aber auch zu nachteiligen elektrischen Eigenschaften des Materials, wie z. B. "shunts", die sich letztendlich in einem schlechteren Wirkungsgrad einer Solarzelle ausdrücken.

Zur Minimierung von Kohlenstoffkontaminationen auf SiliciumOberflächen sind im Stand der Technik verschiedene Methoden bekannt.

In US5445679A wird ein Verfahren zur Reinigung der Oberfläche von polykristallinem Silicium beschrieben. In diesem Verfahren sollen organische Verunreinigungen (unhalogenierte und halogenierte Kohlenwasserstoffe) durch Inkontaktbringen mit einer oxidativen Atmosphäre in flüchtige oder gasförmige Kohlenstoffspezies transferiert und von der Oberfläche entfernt werden. Als oxidative Atmosphäre wird ein oxidatives Plasma eingesetzt, welches durch einen handelsüblichen Hochfrequenzgenerator im Plasmagas erzeugt wird. Als Plasmagas wird entsprechend dem benötigten Oxidationspotenzial ein Inertgas (beispielsweise He, Ne, Ar, Kr, Rn, oder Xe) mit einem Sauerstoffanteil von < 20%, reiner Sauerstoff, reines Inertgas, Sauerstoff und Halogen, Inertgas und Halogen oder reines Halogen verwendet.

Allerdings ist der apparative Aufwand dieses Verfahrens hoch, da ein vakuumdichter Oxidationsreaktor mit Vakuum- und Plasmaerzeugung benötigt wird. Außerdem ist es sehr energieintensiv bei verhältnismäßig langen Prozesszeiten. Zudem zeigt das mittels oxidativen Plasmas gereinigte Polysilicium eine höhere Reaktivität und damit eine zusätzliche Adsorption, so dass das plasmagereinigte Material bei der Weiterverarbeitung (Einkristallziehen) teilweise eine höhere Kontamination zeigt als nicht-plasmagereinigtes Material.

US4555303A beschreibt einen Prozess zur Entfernung von kohlenstoffhaltigem Material von beispielsweise SiliciumOberflächen. Dabei wird das zu reinigende Material in einem Reaktor einem Hochdruck-Sauerstoffplasma (in den Beispielen Helium-Sauerstoff-Mischung mit jeweils einem Sauerstoffgehalt von 32%) ausgesetzt. Die in dem Hochdruck-Hochfrequenzplasma erzeugten reaktiven und ionischen Sauerstoffspezies führen zu einer Reaktion der kohlenstoffhaltigen Schicht und somit zu einer Oxidation dieser Verunreinigungen. Die Reaktionsprodukte Kohlendioxid und möglicherweise ein nicht oxidierter Rückstand (ash material) können leicht mit einer wässrigen Lösung von Natriumhydroxid von der Silicium-Oberfläche entfernt werden.

Allerdings ist der apparative Aufwand dieses Verfahrens hoch, da ein vakuumdichter Oxidationsreaktor mit Plasmaerzeugung benötigt wird. Außerdem ist das Verfahren sehr energieintensiv bei verhältnismäßig langen Prozesszeiten. Die Nassreinigung am Ende des Prozesses führt zu einem erhöhten Aufwand und somit zu hohen Kosten durch die Beschaffung, Aufarbeitung und Vernichtung von Chemikalien. Zudem zeigt das mittels oxidativen Plasmas gereinigte Polysilicium - wie aus US5445679A bekannt - eine höhere Reaktivität und damit eine zusätzliche Adsorption, so dass das plasmagereinigte Material bei der Weiterverarbeitung (Einkristallziehen) eine höhere Kontamination zeigt als nicht-plasmagereinigtes Material.

Aus US2010154357A ist ein Verfahren bekannt, bei dem die Kontamination von Silicium-Bruch während der automatischen Verpackung in einen Kunststoffbeutel minimiert wird. Zur Reduzierung der Kontamination, darunter auch der Kontamination mit Kohlenstoff, werden zur Befüllung der Beutel frei hängende und bewegliche Energieabsorber eingesetzt. Diese Energieabsorber zur Reduzierung des Impulses des Silicium-Bruchs auf den Kunststoffbeutel bestehen aus einem kontaminationsarmen Kunststoff. Unter einem kontaminationsarmen Werkstoff ist ein Werkstoff zu verstehen, der nach einem Kontakt mit dem Polysilicium dessen Oberfläche höchstens wie folgt verunreinigt: Kohlenstoff weniger als 300 pptw. Dies wurde gezeigt, indem das Gewicht des Kunststoff-Schlauches vor und nach dem Befüllen der Beutel bestimmt wurde. Dabei ergab sich ein Kunststoffabrieb (= Kohlenstoffabrieb) unter der Nachweisgrenze von 0,1 mg pro 400 kg, und damit unter den geforderten 300 ng pro kg Si (= 300 pptw). Dieses Verfahren bezieht sich nur auf die Begrenzung des Kontamination bei der Verpackung.

US20030159647A1 offenbart fließfähige Teilchen ("Flowable Chips") aus polykristallinem Silicium mit einer Maximalkonzentration von 0,17 ppma (170 ppba) Kohlenstoff in der Masse (Bulk-Verunreinigung). Über die Konzentration von Kohlenstoff an der Oberfläche gibt US20030159647A1 keine Auskunft.

DE4137521A1 beschreibt ein Verfahren zur Analyse von Spuren an Verunreinigungen auf teilchenförmigem Silicium. Dabei wird eine bestimmte Masse des teilchenförmigen Siliciums in ein Siliciumgefäß, ebenfalls bekannter Masse und Qualität, gefüllt. Dieses gefüllte Siliciumgefäß wird anschließend einem Zonenziehverfahren (Schwebezone) unterzogen, was zu einer monolithischen Einheit aus monokristallinem Silicium zwischen Gefäß und teilchenförmigen Silicium führt. Die Oberflächenverunreinigungen des teilchenförmigen Siliciums werden somit in die Masse des aus dem beschriebenen Prozess entstehenden Einkristalls verteilt. Aus dem Einkristall wird anschließend ein Wafer gesägt, chemisch gereinigt und analysiert. Die quantitative Analyse der im Siliciumwafer vorhandenen Verunreinigungen wird mittels Standardmethoden, wie Photolumineszenzanalyse, FTIR-Spektroskopie und Atomabsorptionsspektroskopie durchgeführt. Die Konzentrationen der Verunreinigungen des teilchenförmigen Siliciums kann anschließend durch einfache Mischungsrechnung ermittelt werden. Der Gehalt an Kohlenstoffverunreinigungen in gesiebten Siliciumfragmenten wird mit < 50 ppb angegeben.

DE4330598A1 beschreibt ein Verfahren zur Analyse von Spuren an Verunreinigungen bei unregelmäßig geformten Siliciumbrocken auf der Oberfläche und in der Masse. Dieser Siliciumbrocken muss dabei einen Durchmesser zwischen 4 und 22 mm und eine Länge von 5 bis 20 cm aufweisen. Dabei wird ein zonenschmelzbarer Siliciumbrocken einem tiegelfreien Zonenschmelzverfahren unterzogen. Die Oberflächenverunreinigungen des unregelmäßigen Körpers werden somit in die Masse des aus dem beschriebenen Prozess entstehenden Einkristalls verteilt. Aus dem Einkristall wird anschließend ein Wafer gesägt, chemisch gereinigt und analysiert. Die quantitative Analyse der im Siliciumwafer vorhandenen Verunreinigungen wird mittels Standardmethoden, wie Photolumineszenzanalyse, FTIR-Spektroskopie und Atomabsorptionsspektroskopie durchgeführt.

Aus der beschriebenen Problematik ergab sich die Aufgabenstellung der Erfindung. Diese bestand darin, ein verbessertes Verfahren zur Entfernung von Kontaminationen mit Kohlenstoff an der Oberfläche von polykristallinem Silicium bereitzustellen sowie ein polykristallines Silicium zugänglich zu machen, dass weniger Kohlenstoff an der Oberfläche aufweist als im Stand der Technik.

Die Aufgabe der Erfindung wird gelöst durch ein polykristallines Siliciumbruchstück mit einer Konzentration von Kohlenstoff an der Oberfläche von 0,5-35 ppbw.

Vorzugsweise beträgt die Konzentration von Kohlenstoff an der Oberfläche 0,5-20 ppbw.

Besonders bevorzugt beträgt die Konzentration von Kohlenstoff an der Oberfläche 0,5-10 ppbw.

Das polykristalline Silicium liegt in Form von Bruchstücken vor. Das polykristalline Silicium ist gekennzeichnet durch eine zerklüftete, tiefe und ungeordnete Spitzen, Vertiefungen, Bruchkanten, Muschelausbrüchen und Risse umfassende Oberfläche.

Das polykristalline Silicium der vorliegenden Erfindung ist zu unterscheiden von polykristallinem Silicium in Granulatform. Letzteres wird in einem grundlegend anderem Prozess (Wirbelschichtreaktor) erzeugt, muss anschließend nicht zerkleinert bzw. gebrochen werden, da es bereits nach Herstellung Schüttguteigenschaften hat. Polysiliciumgranulat besteht aus annähernd kugelförmigen Partikeln der Größe 100-3000 µm. Die Partikel zeigen bis zu einer 100-fachen Vergrößerung keine Zeichen einer mechanischen Bearbeitung, d.h. es sind keinerlei Bruchkanten sichtbar. Granulat ist nicht Gegenstand der vorliegenden Erfindung.

Die Konzentration von Kohlenstoff im Innern des polykristallinen Siliciumbruchstücks beträgt vorzugsweise maximal 10 ppba. Vorzugsweise beträgt die Konzentration von Kohlenstoff im Innern 1 bis 5 ppba. Ganz besonders bevorzugt liegt die Konzentration von Kohlenstoff im Innern unter der Nachweisgrenze von 1 ppba = 0,43 ppbw.

Die für das polykristalline Siliciumbruchstück angegebenen Werte für Oberflächenkohlenstoff gelten unabhängig von der Bruchgröße, die als längste Entfernung zweier Punkte auf der Oberfläche eines Silicium-Bruchstücks (=max. Länge) wie folgt definiert ist:
- Bruchgröße 0 in mm: ca. 0.5 bis 5
- Bruchgröße 1 in mm: ca. 3 bis 15
- Bruchgröße 2 in mm: ca. 10 bis 40
- Bruchgröße 3 in mm: ca. 20 bis 60
- Bruchgröße 4 in mm: ca. > 45

### Herstellung des polykristallinen Siliciums

Im Folgenden wird erläutert, wie sich das erfindungsgemäße polykristalline Siliciumbruchstück herstellen lässt.

### a) Abscheidung von polykristallinem Silicium in einem Siemens-Reaktor

Polykristallines Silicium wird an erhitzten Silicium-Dünnstäben abgeschieden, wobei als Reaktionsgas eine Silicium enthaltende Komponente und Wasserstoff verwendet werden. Vorzugsweise handelt es sich bei der Silicium enthaltenden Komponente um ein Chlorsilan, besonders bevorzugt um Trichlorsilan.

Die Abscheidung erfolgt gemäß Stand der Technik, wobei z.B. auf WO 2009/047107 A2 verwiesen wird.

Um eine Konzentration von Kohlenstoff im Innern des polykristallinen Siliciums von 1 ppba oder weniger zu erreichen, wird vorzugsweise das in der nichtveröffentlichten deutschen Anmeldung mit dem Aktenzeichen 102010040293.1 beschriebene Verfahren verwendet.
Es sieht zwei Abscheidereaktoren zur Abscheidung von Polysilicium aus Trichlorsilan (TCS) und Wasserstoff vor, wobei ein gereinigtes Kondensat aus dem Abgas eines ersten Abscheidereaktors einem zweiten Reaktor zugeführt wird und zur Abscheidung von Polysilicium verwendet wird.
Dabei sind getrennte Wasserstoffkreisläufe für die Abscheidereaktoren vorgesehen, die stofflich voneinander getrennt sind. Zudem wird der Wasserstoffkreislauf der ersten Abscheidung derart kontrolliert, dass damit der TCS-Fluss der zweiten Abscheidung gesteuert werden kann.

Das Abgas aus dem ersten Abscheideprozess wird zunächst kondensiert und anschließend mittels Destillation gereinigt, bevor es im zweiten Abscheideprozess zum Einsatz kommt.

### b) Zerkleinern des polykristallinen Siliciums

Nach der Abscheidung im Siemensreaktor werden die Siliciumstäbe aus dem Reaktor entnommen.

Zur Erzeugung des erfindungsgemäßen Siliciums erfolgt zunächst eine Vorzerkleinerung des Polysiliciumstabs.

Dazu wird ein Hammer aus einem abriebsarmen Werkstoff, z.B. Hartmetall verwendet. Ein Hammerstiel besteht aus Kunststoff.

Der dabei verwendete Kunststoff wird ausgewählt aus einem oder mehreren Elementen der Gruppe bestehend aus Polypropylen, Polyethylen, Polyvinylidenfluorid (PVDF), Polyurethan (PUR) und Polyamid (PA).

Das Vorzerkleinern erfolgt auf einem Arbeitstisch mit einer Oberfläche, die vorzugsweise aus verschleißarmem Kunststoff oder aus Silicium besteht.

Der dabei verwendete Kunststoff wird ebenfalls ausgewählt aus einem oder mehreren Elementen der Gruppe bestehend aus Polypropylen, Polyethylen, Polyvinylidenfluorid (PVDF), Polyurethan (PUR) und Polyamid (PA).

Anschließend erfolgt eine Zerkleinerung des vorzerkleinerten Polysiliciums auf die gewünschte Zielgröße Bruchgröße 0, 1, 2, 3 oder 4.

Die Zerkleinerung erfolgt mittels eines Brechers, z.B. mit einem Backenbrecher.

Ein solcher Brecher ist beispielsweise beschrieben in EP 338 682 A2.

Anschließend wird das gebrochene Silicium mittels eines mechanischen Siebs in Bruchgrößen klassifiziert, wobei das mechanische Sieb mit Kunststoff oder mit Silicium ausgekleidet ist.

Der dabei verwendete Kunststoff wird wiederum ausgewählt aus einem oder mehreren Elementen der Gruppe bestehend aus Polypropylen, Polyethylen, Polyvinylidenfluorid (PVDF), Polyurethan (PUR) und Polyamid (PA).

Beide Anlagen, sowohl Arbeitstisch und Hammer zur Vorzerkleinerung, als auch Brecher befinden sich in einem Reinraum der Klasse kleiner oder gleich 10000.

Vorzugsweise befinden sich die Anlagen in einem Reinraum der Klasse 100 oder besser(nach US FED STD 209E, abgelöst durch ISO 14644-1).

Bei Klasse 100 (ISO 5) dürfen max. 3,5 Partikel von max. 0,5 µm Durchmesser pro Liter enthalten sein.

Vorzugsweise ist im Reinraum ein Ionisationssystem implementiert, um durch aktive Luftionisation elektrostatische Ladungen zu neutralisieren. Ionisatoren durchsetzen die Reinraumluft derart mit Ionen, dass statische Ladungen an Isolatoren und ungeerdeten Leitern abgebaut werden.

Zum Auskleiden von Metallteilen am Brecher wird wenigstens ein Kunststoff, ausgewählt aus einem oder mehreren Elementen der Gruppe bestehend aus Polypropylen, Polyethylen, Polyvinylidenfluorid (PVDF), Polyurethan (PUR) und Polyamid (PA), verwendet.

### c) Reinigung des polykristallinen Siliciums durch thermische Behandlung

Nach den Zerkleinerungsvorgängen erfolgt eine thermische Behandlung des polykristallinen Siliciums.

Die Aufgabe der Erfindung wird nämlich auch gelöst durch ein Verfahren zur Reinigung von polykristallinem Silicium mit Kohlenstoff-Kontaminationen an der Oberfläche, umfassend eine thermische Behandlung des polykristallinen Siliciums in einem Reaktor bei einer Temperatur von 350 bis 600°C, wobei sich das polykristalline Silicium in einer Inertgasatmosphäre befindet, wobei das polykristalline Silicium nach der thermischen Behandlung eine Konzentration von Kohlenstoff an der Oberfläche von 0,5-35 ppbw aufweist.

Vorzugsweise erfolgt die thermische Behandlung in einem Ofen.

Beispielweise eignet sich hierfür ein Durchlaufofen vom Typ DM 900/11 der Fa. THERMCONCEPT Dr. Fischer GmbH & Co. KG.

Vorzugsweise erfolgt die thermische Behandlung bei einem konstanten Inertgasfluss zwischen 0-250 L/min.

Das Verfahren wird vorzugsweise bei einem geringen Inertgasüberdruck von ca. 50 hPa zur Atmosphäre durchgeführt.

Als Inertgase können Edelgase oder Stickstoff verwendet werden.

Bevorzugt wird das Edelgas Argon und nicht Stickstoff verwendet, um einer etwaigen Siliciumnitridbildung vorzubeugen.

Die thermische Behandlung erfolgt unter Ausschluss von Sauerstoff. Damit lassen sich reaktive Siliciumoberflächen, die zu Rekontamination führen können, vermeiden.

Vorzugsweise erfolgt die thermische Behandlung nur kurzzeitig für eine Dauer von bis zu 180 s, bevorzugt jedoch für wenigstens 30 s.

Vorzugsweise erfolgt die thermische Behandlung bei einer Temperatur von 450 bis 550°C.

Vorzugsweise befindet sich das polykristalline Silicium während der thermischen Behandlung auf einer oder mehreren Schalen aus Quarz oder aus Silicium. Beispielsweise kann sich auf einer solchen Schale eine Menge von 5 kg an gebrochenem oder gekörntem Silicium befinden.

Nach der thermischen Behandlung erfolgt eine Abkühlung des thermisch behandelten Polysiliciums außerhalb des Ofens unter Inertgasspülung annähernd auf Raumtemperatur.

Im Rahmen der Entwicklung dieses Reinigungsverfahren wurde festgestellt, dass sich spezielle Kunststoffe, wie Polyethylen und Polypropylen, quantitativ von Oberflächen polykristallinen Siliciums entfernen lassen, indem das Silicium in einem Ofen idealerweise unter einem Inertgasstrom und mit kontrollierter Aufheizrampe kurzzeitig erhitzt und anschließend im inertisierten Zustand wieder abgekühlt wird.

Das kontrollierte Aufheizen des zu behandelnden Siliciums geschieht vorzugsweise wie folgt:

Der Durchlaufofen wird bei konstanter Prozesstemperatur betrieben.

Das auf der Prozessschale gleichmäßig ausgebreitete zu behandelnde polykristalline Silicium wird auf den Kettenförderer des Durchlaufofens aufgegeben und unter Inertgasspülung in die Ofenkammer befördert.

Da im Ofen eine Behandlung der Oberfläche des Prozessguts durchgeführt wird, ist eine vollständige Erhitzung der gesamten Masse des Prozessguts nicht notwendig.

Bei konstanter Siliciummasse pro Prozessschale (ca. 5 kg) und idealer Verteilung des Siliciums auf der Prozessschale wurde eine konstante Aufheizzeit von 30 s ermittelt, die ausreichend ist, um die kohlenstoffhaltigen Verunreinigungen auf der Oberfläche des polykristallinen Siliciums und die oberste Siliciumschicht der Siliciumpartikel von Raumtemperatur auf Prozesstemperatur zu erhitzen.

Das Abkühlen des Prozessguts auf Raumtemperatur erfolgt in inertisiertem Zustand nach dem Durchlauf der beladenen Prozessschale durch die Ofenkammer in der Kühleinheit des Durchlaufofens innerhalb von 3 Minuten.

Vorteilhaft ist, dass in den Prozessen unmittelbar vor der Reinigung kein erheblicher technischer Aufwand für eine Minimierung der Oberflächenkontamination der Polysiliciumpartikel oder -bruchstücke mit Polymerabrieb betrieben werden muss, sondern nur darauf geachtet werden muss, dass polymere Hilfsstoffe eingesetzt werden, die mit Hilfe des beschriebenen thermischen Verfahrens leicht entfernt werden können.

Das Ergebnis ist überraschend, zumal thermodynamische Grundlagen von der Reaktion zwischen einer kohlenstoffhaltigen Oberflächenkontamination und einer Siliciumoberfläche etwas anderes erwarten ließen.

Bei einer Erhitzung von einem mit organischen Polymeren verunreinigten Polysilicium unter Sauerstoffausschluss war nämlich eine Reduktion der organischen Verbindung zu Kohlenstoff zu erwarten.
Dies wäre problematisch gewesen, da eine nachfolgende Reduktion des Siliciumoxids aus der Oxidschicht eines Siliciumpartikels durch den an der Partikeloberfläche anhaftenden elementaren Kohlenstoff zu metallischem Silicium und flüchtigem Kohlendioxid bei einer Temperatur von 350°C bis 600°C nach dem erfindungsgemäßen Verfahren nicht möglich ist. Selbst bei einer Temperatur von bis zu 1400°C wäre dies nicht realisierbar.

Überraschenderweise führten die gewählten Aufheizrampen und die bevorzugt gewählte Inertgas-Flussrate jedoch zu einer weitgehend rückstandlosen thermischen Desorption des Oberflächen-Kohlenstoffs.

Überraschenderweise basiert dieses nicht-oxidative Reinigungsverfahren für Kohlenwasserstoffe auf Siliciumoberflächen auf dem physikalischen Prinzip der Verdampfung bzw. der nicht-oxidativen Pyrolyse in einem bestimmten Temperaturbereich unter bestimmten gaskinetischen Bedingungen.

Polyethylen besitzt eine Schmelztemperatur zwischen 105 und 135°C (T_{M}(PE-LD)=105-110°C) ; (T_{M}(PE-HD)=130-135°C) [2].

Wird Polyethylen unter Luftausschluss erhöhten Temperaturen ausgesetzt, so bilden sich ab 280°C gasförmige Kohlenwasserstoffe ohne Zersetzung des Polymers zum Monomer, wobei dieser Effekt bis Temperaturen von 350°C verstärkt zu beobachten ist.

Die Bildung von großen Mengen flüchtiger Produkte bei Erhitzung ist eine grundlegende Eigenschaft von thermoplastischen organischen Polymeren, wie beispielsweise Polyethylen und Polypropylen, wobei die thermische Stabilität von Polypropylen bis 315°C gegeben ist.

Der Schmelzpunkt von Polypropylen liegt bei 158 bis 166°C.

Nicht nur das Polypropylen an sich, sondern auch die meisten im PP enthaltenen organischen Additive verdampfen bei Temperaturen bis ca. 300°C und werden bei Temperaturen über 300°C thermisch abgebaut bzw. pyrolysiert.

Grundsätzlich ist die thermische Beständigkeit von unstabilisiertem Polypropylen geringer als die von Polyethylen.

Halogenierte Polymere, wie beispielsweise PVDF, sind gegen einen thermischen Abbau wesentlich stabiler.

PVDF ist bis Temperaturen von 410°C weitgehend beständig und bildet dann merklich gasförmige Spaltprodukte, darunter Fluorwasserstoff als Hauptprodukt.

PU hingegen zersetzt sich unter Inertgasatmosphäre in einem sehr breiten Temperaturbereich zwischen 245 und 535°C in zwei Stufen mit den beiden Maxima bei 353 und 414°C und einem Rückstand von ca. 15% als verkohlter Rest.

Bevorzugt ist bei der Auskleidung von Teilen an den Zerkleinerungswerkzeugen die Verwendung von Kunststoffen, die sich durch Thermodesorption vollständig von der Siliciumoberfläche entfernen lassen.

Besonders bevorzugt ist die Verwendung von Polyethylen und Polypropylen.

### d) Nasschemische Reinigung des polykristallinen Siliciums

Optional wird das polykristalline Silicium gereinigt.

Dazu werden die Polysiliciumbruchstücke in einer Vorreinigung in zumindest einer Stufe mit einer oxidierenden Reinigungslösung gewaschen, in einer Hauptreinigung in einer weiteren Stufe mit einer Reinigungslösung gewaschen, die Salpetersäure und Fluorwasserstoffsäure enthält, und bei einer Hydrophilierung in noch einer weiteren Stufe mit einer oxidierenden Reinigungsflüssigkeit gewaschen.

Die Vorreinigung erfolgt vorzugsweise mittels HF/HCl/H₂O₂.
Die Hydrophilierung der Siliciumoberfläche erfolgt vorzugsweise mittels HCl/H₂O₂.

Die Reinigungsanlage befindet sich vorzugsweise in einem Reinraum der Klasse kleiner oder gleich 10000, vorzugsweise in einem Reinraum der Klasse 100 oder besser.

### e) Verpackung des polykristallinen Siliciums

Das polykristalline Silicium wird vorzugsweise gemäß US2010154357A verpackt. Durch Verwendung eines frei hängenden und beweglichen Energieabsorber zur Befüllung der Kunststoffbeutel, wobei Energieabsorber und Kunststoffbeutel aus einem kontaminationsarmen Werkstoff bestehen, kann die Kontamination des polykristallinen Siliciums mit Kohlenstoff durch Verpackung auf max. 300 pptw bzw. max. 0,3 ppbw beschränkt werden.

### Messung der Oberflächenkontamination mit Kohlenstoff

### a) mittels automatischem Analysator

Die quantitative Bestimmung des Oberflächenkohlenstoffgehaltes von polykristallinem Silicium wird an einem modifizierten Kohlenstoffanalysator RC612 der Fa. Leco Corporation, USA, durch die vollständige Oxidation aller Oberflächenkohlenstoffkontaminationen mit Sauerstoff zu Kohlendioxid durchgeführt.

Die Kohlendioxidkonzentration im Messgas wird standardmäßig mittels einer im Messgerät integrierten Infrarot-Durchflussmesszelle bestimmt.

Das Ergebnis wird anschließend als Massenanteil Oberflächenkohlenstoff bezogen auf die Probenmasse errechnet.

Der Analysator wurde zusätzlich mit einer Einheit zur Sauerstoffvorreinigung ausgestattet.

Diese Einheit oxidiert mögliche Spuren von Kohlenwasserstoffen im Sauerstoff vor dem Kontakt mit der Messprobe katalytisch mit Kupferoxid bei 600°C zu Kohlendioxid und entfernt das gebildete Kohlendioxid sowie Wasser mittels geeigneter Absorptionsmedien (Magnesiumperchlorat und Natriumhydroxid) vollständig aus dem Sauerstoff.

Diese Vorreinigung erlaubt den Einsatz von technischem Sauerstoff aus Druckgasflaschen mit einer Reinheit von >99,5% (Qualität O₂ 2.5).

Versuche mit sehr reinem Sauerstoff der Qualität 5.0 (>99,999%) führten zu keinem verbesserten Ergebnis.

Nach der Vorreinigung wird der Sauerstoff in das horizontal angeordnete beheizte Ofenrohr aus Quarz geführt.

Das Ofenrohr bildet ein zur Atmosphäre offenes System.

Das Eindringen von Luft in das Ofenrohr wird durch einen permanenten Spülstrom von 4 L/min mit vorgereinigtem Sauerstoff in Richtung Ofenrohröffnung zur Atmosphäre hin unterbunden.

Ein geringerer Strom von 0,75 L/min vorgereinigten Sauerstoffs wird in die zur Ofenrohröffnung entgegen gesetzte Richtung geführt und streicht an der Messposition über die in einem Probenschiffchen platzierte Probe.

Die Ofentemperatur beträgt an der Messposition konstant 1000°C.

Alle Messungen, wie Kalibration, Proben- und Blindwertbestimmungen, werden bei dieser Temperatur durchgeführt.

Das Messgas, angereichert mit den Oxidationsprodukten aus der Reaktion des Sauerstoffs mit den Oberflächenkohlenstoffkontaminationen des polykristallinen Siliciums, wird nach dem Verlassen des Ofenrohrs durch eine Nachbrennkammer bei 850°C geführt und anschließend an einem Kupferoxid-Katalysator bei 750°C vollständig zu Kohlendioxid oxidiert.

Der Kohlendioxidgehalt im Messgas wird in der Folge standardmäßig mittels Infrarotspektroskopie an einer Durchflussmesszelle mit einer Länge von 152,4mm (6 inches) bei ∼2349 cm⁻¹ bestimmt.

Bevor das Messgas über einen Kamin das Messgerät verlässt, wird es durch Absorptionsmedien, die auch in der Sauerstoffvorreinigung Verwendung finden, von Kohlendioxid und Wasser gereinigt.

Die Kalibration des Messgerätes erfolgt mit Caliciumcarbonat-Standards in Probenschiffchen aus Quarz.

Um Verschleppungen zu vermeiden, werden Probenmessungen und Blindwertbestimmung in eigens dafür vorgesehenen Quarz-Schiffchen durchgeführt.

Da bei Messungen im Spurenbereich Einflüsse, wie beispielsweise am Quarzschiffchen adsorbiertes Kohlendioxid aus der Raumluft und gewöhnlicher Hausstaub im Labor, das Messergebnis verfälschen können, befindet sich das leere Messschiffchen mit geringen Ausnahmen permanent im vorderen Bereich des Ofenrohrs.

Die Temperatur in diesem Bereich des Ofenrohrs beträgt ca. 350°C.

Dieser Ofenbereich wird permanent mit zuvor gereinigtem Sauerstoff gespült.

Die Blindwertmessungen, die unmittelbar vor jeder Probenmessung statt finden, werden mit diesem leeren Messschiffchen durchgeführt.

Dabei wird exakt der wie folgt beschriebene Messprozess, jedoch ohne Probenmaterial durchlaufen.

Auf Grund der Empfindlichkeit der Messung werden vor jeder neuen Probenserie fünf Blindwertmessungen durchgeführt. Liegen diese Blindwerte auf Basislinienniveau, dann ist das Gerät bereit für die Messung.

Zur Bestimmung des Oberflächenkohlenstoffgehaltes an einer Siliciumprobe, werden ca. 1,5 g dieser Probe in ein Wägeschiffchen aus Quarz an einer Analysenwaage eingewogen.

Als Waage eignet sich beispielsweise das Modell CPA224S der Fa. Sartorius AG, Deutschland.

Per Knopfdruck wird die exakte Einwaage über eine Schnittstelle an den Analysator übermittelt.

Das sich im vorderen Bereich des Ofenrohrs befindliche leere Messschiffchen wird nun zur Abkühlung an der Raumluft auf < 100°C für eine Dauer von 100-300 s, bevorzugt 120 s, aus dem Ofenrohr entfernt und weitgehend geschützt vor Staub aufbewahrt.

Nach der Abkühlung wird das leere Messschiffchen etwa zur Hälfte in das offene Ofenrohr gesteckt, so dass ein Umfüllen der Probe vom Wägeschiffchen in das erkaltete und mit vorgereinigtem Sauerstoff gespülte Messschiffchen noch möglich ist.

Das mit Probe gefüllte Schiffchen wird anschließend mit einem Greifer aus Quarz in die Messposition geschoben und die Messung manuell gestartet.

Nach einer Messzeit von 55 s ist die Messung abgeschlossen.

Das Ergebnis wird am Analysator in der Einheit ppmw angezeigt.

Das Messschiffchen wird anschließend mit dem Greifer ans vordere Ende des Ofenrohrs geschoben, entleert und zur Abkühlung, wie vorher beschrieben, weitgehend staubfrei vor dem Analysator platziert.

Es werden nun nacheinander vier Wiederholungsmessungen derselben Probe (entspricht einer Probenserie) angefertigt und der arithmetische Mittelwert aus den Messergebnissen einer Probenserie errechnet.

Nach einer Probenserie erfolgt eine weitere Blindwertmessung, um zu überprüfen, ob während einer Probenserie eine Drift stattgefunden hat.

Um einen Messfehler bei einer möglichen unvollständigen Oxidation von Kohlenstoffverbindungen zu Kohlenmonoxid abschätzen zu können, der mittels der standardmäßigen IR-Messzelle nicht detektiert werden kann, wurden zusätzliche Gasmessungen durchgeführt.

Da das gesamte Abgas des Verbrennungsanalysators in die Raumluft abgegeben wird, mussten zum Schutz des unmittelbar am Gerät arbeitenden Bedienpersonals Konzentrationsmessungen im Messgas hinsichtlich Kohlendioxid und Kohlenmonoxid bei sehr tiefen analytischen Nachweisgrenzen durchgeführt werden.

Der unmittelbar nach der integrierten IR-Messzelle gemessene Kohlendioxidgehalt im Messgas entspricht somit der Maximalbelastung der Atemluft im Messraum bei einem Totalversagen des Kohlendioxidadsorbers vor dem Abgaskamin.

Gegebenenfalls entstandenes Kohlenmonoxid würde direkt in die Atemluft abgegeben werden.

Zur Überprüfung der Kohlenmonoxid- und Kohlendioxidkonzentrationen im Messgas unmittelbar nach der IR-Messzelle wurde der Multikomponentenanalysator Prismati™ der Fa. Tiger Optics LLC, USA verwendet, der simultan neben weiteren Komponenten im Gas Kohlenmonoxid und Kohlendioxid mit Nachweisgrenzen von je 100 ppb bestimmen kann.

Die somit verwendete Cavity Ring-Down Spektroskopie (CRDS) ist deutlich nachweisstärker als die Infrarotspektroskopie.

Zur Durchführung der Messung wurde das Messgas unmittelbar nach der IR-Durchfluss-messzelle über ein Rohr an die Durchflussmesszelle des CRDS herangeführt.

Das durch beide Durchflussmesszellen geströmte Messgas fließt anschließend durch die beiden letzten Adsorber des Verbrennungsanalysators, um dann über den Kamin an die Raumluft abgegeben zu werden.

Das Vorhandensein von giftigem Kohlenmonoxid im Messgas während der Analyse konnte zu keinem Zeitpunkt mittels CRDS nachgewiesen werden.

Es ist somit davon auszugehen, dass bei den im Verbrennungsofen herrschenden Bedingungen während der Messung eine vollständige Oxidation von Kohlenstoffverbindungen zu Kohlendioxid erfolgt und somit der Fehler durch eine unvollständige Oxidation gegen Null tendiert.

Die in den Messgasen mittels CRDS gemessenen Kohlendioxidkonzentrationen lagen ebenfalls zu keinem Zeitpunkt in einem für die Arbeitssicherheit bedenklichen Bereich.

Überraschenderweise zeigte sich jedoch bei der Verwendung des CRDS als Kohlendioxiddetektor im Vergleich zur standardmäßigen IR-Messzelle des Verbrennungsanalysators eine deutlich tiefere analytische Nachweisgrenze.

Die analytische Nachweisgrenze (NWG) bei der Bestimmung der Oberflächenkohlenstoffkonzentration mittels CRDS als Messprinzip für die Kohlendioxidkonzentrationsmessung im Messgas beträgt 0,020 ppmw (20 ppbw).

Der gesamte Messprozess zur Bestimmung der Oberflächenkohlenstoffkontamination wird in einer Laminar-Flow-Box mit der Reinheitsklasse 7 (10.000; nach ISO 14644-1) durchgeführt.

Unmittelbar vor der Laminar-Flow-Box wurde ein Reinraum der Reinheitsklasse 8 (100.000; nach ISO 14644-1) aufgebaut, der als Schleuse bzw. Aufenthaltsbereich des Bedienpersonals dient.

Diese reine Umgebung reduziert Umfeldeinflüsse durch Staub bei der Bestimmung der Oberflächenkohlenstoffkonzentration auf polykristallinem Silicium deutlich.

### b) Verbesserte Messmethode mit niedrigerer Nachweisgrenze

Bei einer Kohlenstoffkonzentration von weniger als 20 ppbw wird ein alternatives Messverfahren verwendet.

Die Kohlenstoff-Oberflächenverunreinigungen von polykristallinem Silicium lassen sich auch bestimmen, indem von zwei durch Abscheidung in einem Siemensreaktor erzeugten polykristallinen Siliciumstäben der eine Stab unmittelbar nach der Abscheidung hinsichtlich Verunreinigungen mit Kohlenstoff (Bulk und Oberfläche) untersucht wird, während der zweite Stab die Anlagen, in denen der Stab weiterverarbeitet wird, durchläuft und nach Durchlaufen der Anlagen ebenfalls hinsichtlich Verunreinigungen mit Kohlenstoff (Bulk und Oberfläche) untersucht wird. Da beiden Stäben das gleiche Niveau an Bulk-Verunreinigungen zugeordnet werden kann, ergibt sich durch Differenz der beiden ermittelten Verunreinigungen die Oberflächenverunreinigung, die durch die Weiterverarbeitungsschritte wie Zerkleinern, Reinigen, Transportieren verursacht wird. Dies kann zumindest dann sichergestellt werden, wenn Stab und dessen Bruderstab auf ein-und demselben U-förmigen Trägerkörper abgeschieden wurden.

Auf einem Arbeitstisch mit seitlichen Oberflächen aus Kunststoff wird ein polykristalliner Siliciumstab mittels eines Hammers aus Hartmetall mit einem Stiel aus Kunststoff zerkleinert.

Der Arbeitstisch befindet sich in einem Reinraum der Klasse 10000 mit Reinraumfiltern mit PTFE-Membran.

Manuelles Handling des Stabs erfolgt mittels Handschuhen aus hochreinen PE.

An der Seite des Arbeitstisches wird ein 10 bis 20 cm langer polykristalliner Stab mit einem Durchmesser von 1,6 cm für 10 Minuten ausgelegt. Diese Zeit entspricht der mittleren Verweildauer des Materials auf dem Arbeitstisch, bis es in den PE-Beutel verpackt wird.

Zusätzlich wird der am Arbeitstisch ausgelegte Stab durch den Brecher geführt, ohne ihn zu zerkleinern, wodurch er jedoch der Umgebung des Brechers ausgesetzt ist.

Der Brecher befindet sich in einem Reinraum der Klasse 10000.

Zum Auskleiden von Metallteilen am Brecher wurden Polypropylen und Polyethylen verwendet.

Nach Durchlaufen des Brechers wird der Stab verpackt und anschließend auf Verunreinigungen mit Kohlenstoff analysiert.

Dies erfolgt mittels FTIR (SEMI MF 1188, SEMI MF 1391).

Dabei wird aus dem polykristallinen Stab zunächst ein FZ-Einkristall gewachsen. Vom Einkristall wird anschließend eine Messscheibe entnommen und mittels FTIR untersucht.

Der untersuchte polykristalline Stab hat einen Bruderstab, der gleichzeitig unter denselben Bedingungen auf einem U-förmigen Trägerkörper in einem Siemens-Reaktor abgeschieden wurde. Nach der Abscheidung wurde der U-förmige Trägerkörper aus dem Reaktor entnommen, die Brücke abgetrennt, so dass jeweils ein Stab und ein Bruderstab erhalten wurden. Der Bruderstab wurde unmittelbar nach der Abscheidung in einen PE-Beutel verpackt und anschließend mittels FTIR auf Verunreinigungen mit Kohlenstoff untersucht.

Da beide Stäbe, Stab und Bruderstab, unter denselben Bedingungen auf demselben U-förmigen Trägerkörper abgeschieden wurden, wiesen sie nach Abscheidung das gleiche Niveau an Kohlenstoff-Kontamination auf.

Der polykristalline Stab, der während des Zerkleinerns auf dem Arbeitstisch abgelegt war bzw. durch den Brecher geführt wurde, war jedoch anschließend der Umgebung der Zerkleinerungsvorgänge ausgesetzt und wurde dadurch gegebenenfalls kontaminiert. Durch Differenzbildung der für Stab und Bruderstab ermittelten Kohlenstoffkonzentrationen ergibt sich die Kontamination mit Kohlenstoff an der Oberfläche.

Es konnte gezeigt werden, dass die zusätzliche Kontamination durch die erfindungsgemäße Reinigung mittels thermischer Behandlung auf ein äußerst niedriges Niveau beschränkt werden konnte.

### Beispiele

Im Folgenden wird die Erfindung anhand von Beispielen erläutert.

### Beispiel 1

Nach Beendigung der mechanischen Bearbeitungsprozesse, also Vorzerkleinern und Zerkleinerung auf BG 1 wie unter b) Zerkleinerung des polykristallinen Siliciums beschrieben, wurde eine Teilmenge von ca. 5 kg polykristallines Silicium der Bruchgröße 1 entnommen.

Aus dieser Teilmenge wurde wiederum eine repräsentative Probe von ca. 0,1 kg zur Bestimmung der Oberflächenkohlenstoffkontamination vor dem thermischen Reinigungsprozess entnommen.

Die Oberflächenkohlenstoffkonzentration dieses Materials liegt typischerweise in einem Bereich zwischen 70 und 180 ppbw.

Die verbliebenen 4,9 kg an polykristallinem Silicium wurden dem erfindungsgemäßen thermischen Reinigungsprozess unterzogen.

Dabei wurde das zu reinigende polykristalline Silicium auf einer Prozessschale aus Quarz oder Silicium ausgebreitet.

Dieses Material wurde anschließend unter einer inerten Argonatmosphäre ohne Gasfluss, somit unter Ausschluss von Sauerstoff, im Ofen für eine Dauer von 30 s einer Temperatur von 500°C ausgesetzt.

Der Inertgasüberdruck war dabei vernachlässigbar gering.

Nach dem thermischen Reinigungsprozess und der Abkühlung des polykristallinen Siliciums auf Raumtemperatur wurde erneut eine repräsentative Probe von ca. 0,1 kg aus der Restmenge zur Bestimmung der Oberflächenkohlenstoffkontamination entnommen.

Als Probengefäß können sowohl Gefäße aus Kunststoff, wie beispielsweise hochreine Kunststoffbeutel, als auch aus Glas verwendet werden.

Im Beispiel wurde eine handelsübliche Weithals-Laborglasflasche aus Borsilikatglas verwendet.

Die Bestimmungen der Oberflächenkohlenstoffkontaminationen der Proben vor und nach der thermischen Reinigung erfolgten wie zuvor bereits beschrieben (automatischer Analysator).

Diese Untersuchungen wurden bei insgesamt zehn Produktionschargen durchgeführt.

**Tabelle 1** zeigt, wie sich die Konzentration an Oberflächenkohlenstoff durch einen erfindungsgemäßen thermischen Reinigungsprozesses ohne Inertgasfluss bei polykristallinem Silicium der Bruchgröße 1 verbessert.

**Tabelle 1**

| **Charge** | **Oberflächenkohlenstoffkontamination vor der thermischen Reinigung [ppmw]** | **Oberflächenkohlenstoffkontamination nach der thermischen Reinigung [ppbw]** |
|---|---|---|
| 1 | 0,133 | 0,022 |
| 2 | 0,085 | 0,025 |
| 3 | 0,162 | 0,021 |
| 4 | 0,096 | 0,027 |
| 5 | 0,176 | 0,035 |
| 6 | 0,142 | 0,022 |
| 7 | 0,128 | 0,032 |
| 8 | 0,157 | 0,022 |
| 9 | 0,149 | 0,029 |
| 10 | 0,121 | 0,026 |

### Beispiel 2

Auch hier wurde nach Beendigung der mechanischen Bearbeitungsprozesse eine Teilmenge von ca. 5 kg polykristallines Silicium der Bruchgröße 1 entnommen.

Aus dieser Teilmenge wurde wiederum eine repräsentative Probe von ca. 0,1 kg zur Bestimmung der Oberflächenkohlenstoff - kontamination vor dem thermischen Reinigungsprozess entnommen.

Die Oberflächenkohlenstoffkonzentration dieses Materials liegt typischerweise in einem Bereich zwischen 70 und 180 ppbw.

Die verbliebenen 4,9 kg an polykristallinem Silicium wurden dem erfindungsgemäßen thermischen Reinigungsprozess unterzogen.

Dabei wurde das zu reinigende polykristalline Silicium auf einer Prozessschale aus Quarz oder Silicium ausgebreitet.

Dieses Material wurde anschließend unter einem konstanten Argonfluss von 100 L/min, somit unter Ausschluss von Sauerstoff, im Ofen für eine Dauer von 30 s einer Temperatur von 500°C ausgesetzt.

Der Inertgasüberdruck war dabei vernachlässigbar gering.

Nach dem thermischen Reinigungsprozess und der Abkühlung des polykristallinen Siliciums auf Raumtemperatur wurde erneut eine repräsentative Probe von ca. 0,1 kg aus der Restmenge zur Bestimmung der Oberflächenkohlenstoffkontamination entnommen.

Als Probengefäß wurde eine Weithals-Laborglasflaschen aus Borsilikatglas verwendet.

Die Bestimmungen der Oberflächenkohlenstoffkontaminationen der Proben vor und nach der thermischen Reinigung erfolgten wie zuvor beschrieben (automatischer Analysator) .

Diese Untersuchung wurde bei insgesamt zehn Produktionschargen durchgeführt.

**Tabelle 2** zeigt, wie sich die Konzentration an Oberflächenkohlenstoff durch einen erfindungsgemäßen thermischen Reinigungsprozesses unter Inertgasfluss bei Material der Bruchgröße 1 verbessert.

Die ermittelten Werte nach der thermischen Reinigung lagen unter der Nachweisgrenze des Analysators, also kleiner als 20 ppbw.

Die thermische Reinigung unter Inertgasfluss ist also besonders effektiv und damit im Rahmen der Erfindung besonders bevorzugt.

**Tabelle 2**

| **Charge** | **Oberflächenkohlenstoffkontamination vor der thermischen Reinigung [ppmw]** | **Oberflächenkohlenstoffkontamination nach der thermischen Reinigung [ppmw]** |
|---|---|---|
| 1 | 0,178 | < 0,020 |
| 2 | 0,139 | < 0,020 |
| 3 | 0,142 | < 0,020 |
| 4 | 0,159 | < 0,020 |
| 5 | 0,176 | < 0,020 |
| 6 | 0,078 | < 0,020 |
| 7 | 0,135 | < 0,020 |
| 8 | 0,169 | < 0,020 |
| 9 | 0,113 | < 0,020 |
| 10 | 0,122 | < 0,020 |

### Beispiel 3

27 polykristalline Siliciumstäbe, jeweils 10 bis 20 cm lang und mit einem Durchmesser von jeweils 1,6 cm, wurden den Bedingungen der Vorzerkleinerung und der Bearbeitung mit einem Brecher ausgesetzt.

Die Stäbe wurden jeweils auf einem Arbeitstisch abgelegt, während auf diesem ein Stab mittels eines Hammers zerkleinert wurde. Zudem wurden die Stäbe durch den Brecher geführt, ohne eine Zerkleinerung vorzunehmen.

Nachfolgend folgte eine thermische Behandlung jedes dieser Stäbe analog **Beispiel 2.**

Abweichend von **Beispiel 2** erfolgte anschließend ein zusätzlicher nasschemischer Prozess.

Es konnte gezeigt werden, dass die zusätzliche nasschemische Reinigung zu gegenüber **Beispiel 2** noch besseren Werten für Oberflächenverunreinigungen mit Kohlenstoff führt.

In diesem Fall musste die zuvor erwähnte alternative Messmethode benutzt werden, welche die quantitative Bestimmung von Oberflächenkohlenstoffverunreinigungen mittels der nachweisstärkeren FTIR-Spektroskopie ermöglicht.

Als Referenz diente jeweils ein unbehandelter Bruderstab von einem U-förmigen Trägerkörper aus derselben Abscheidecharge. Je zwei Filamentstäbe waren während der Abscheidung über eine waagrechte Brücke gekoppelt und bildeten jenen U-förmigen Trägerkörper für die Siliciumabscheidung. Nach Abscheidung ergaben sich nach Abtrennung der Brücke jeweils zwei Stäbe: Stab und Bruderstab.

Nach Abscheidung und Abtrennen der Brücke wurden Stab und Bruderstab jeweils in einen PE-Beutel verpackt.

Bei allen 27 Stäben und Bruderstäben wurde wie folgt verfahren:

Der Bruderstab wurde in ein Labor zur Bestimmung der Kohlenstoffkonzentration transportiert.

Der Stab wurde durch die Produktion geführt.

Zum Öffnen des PE-Beutels wurde eine Keramikschere verwendet. Nach Öffnen des Beutels wurde der Stab mittels eines hochreinen PE-Handschuhs manuell entnommen.

Anschließend wurde der Stab auf den Arbeitstisch zur manuellen Vorzerkleinerung von Siliciumstäben in Produktionsgröße gelegt.

Es war darauf zu achten, dass der Stab während seines Durchlaufes durch alle Prozesse der mechanischen Bearbeitung mechanisch unversehrt blieb, d. h. nicht zerbrach.

Der Arbeitstisch wurde anschließend mit einem Siliciumstab aus der Produktion beladen.

Das Vorzerkleinern erfolgte auf einem Arbeitstisch mit einer Oberfläche, die aus Polypropylen bestand. Die seitlichen Teile des Tisches waren ebenfalls mit Polypropylen ummantelt. Ebenso können auch Polyethylen, Polyvinylidenfluorid (PVDF), Polyurethan (PUR) und Polyamid (PA) als Oberfläche und zur Ummantelung verwendet werden.

Zur Zerkleinerung wurde ein Hammer aus einem abriebsarmen Werkstoff, z.B. Hartmetall verwendet. Der Hammerstiel bestand aus Polypropylen. Ebenso können auch Polyethylen, Polyurethan, Polyamid und Polyvinylidenfluorid (PVDF) verwendet werden.

Der Stab hielt während der Vorzerkleinerung des Polysiliciumstabs aus der Produktion direkten Kontakt mit dem gebrochenen Silicium und dem am Arbeitstisch verwendeten Kunststoff.

Der Stab wurde somit während der Vorzerkleinerung in gleicher Weise verunreinigt, wie das gebrochene Polysilicium des Stabes aus der Produktion, da der Stab in gleicher Weise intensiv mit Kunststoff abgerieben wurde.

Anschließend erfolgte eine Zerkleinerung des gebrochenen Siliciums auf Bruchgrößen BG0 bis BG4.

Die Zerkleinerung erfolgte mittels eines Backenbrechers.

Metallteile am Brecher waren mit Polypropylen und Polyethylen ausgekleidet.

Beide Anlagen, sowohl Arbeitstisch und Hammer zur Vorzerkleinerung, als auch Brecher befanden sich in einem Reinraum der Klasse kleiner oder gleich 100.

Anschließend wurde das gebrochene Silicium mittels eines mechanischen Siebs in Bruchgrößen klassifiziert, wobei das mechanische Sieb mit Polypropylen ausgekleidet war.

Am Ende der mechanischen Bearbeitungsprozesse lag der Stab eingebettet in einen Schüttkegel aus gebrochenem Polysilicium der Bruchgröße BG0.

Durch diesen intensiven Kontakt zwischen Stab und Polysilicium-Bruch BG0 war gewährleistet, dass der Stab mit Oberflächenverunreinigungen derselben Art und Menge kontaminiert wurde, wie sie auch auf der Oberfläche des Polysiliciumbruchs BG0 vorhanden sind.

Die Oberflächenkohlenstoffkonzentration von Polysilicium der Bruchgröße BG0 beträgt typischerweise zwischen 0,400 und 0,600 ppmw.

Die Aufbewahrungszeit des Stabs im Schüttkegel betrug 15 Minuten.

Der kontaminierte Stab wurde anschließend aus dem Schüttkegel entnommen. Dies erfolgte manuell mittels eines PE-Handschuhs. Der Stab wurde in einen hochreinen PE-Beutel verpackt und verschweißt.

Der verpackte Stab wurde anschließend zum Ofen transportiert, um die erfindungsgemäße thermische Desorption durchzuführen.

Der PE-Beutel, in den der kontaminierte Stab verpackt war, wurde mittels einer Keramikschere geöffnet. Der Stab wurde entnommen und auf eine Prozessschale aus Quarz oder Silicium im Ofen gelegt, wobei zur manuellen Entnahme und zum Einbringen in den Ofen ein hochreiner PE-Handschuh benutzt wurde.

Dann erfolgte die erfindungsgemäße thermische Reinigung im Ofen.

Der thermisch behandelte Stab wurde anschließend einem nasschemischen Reinigungsprozess unterzogen.

Dazu wurde der thermisch gereinigte Stab in einem dreistufigen nasschemischen Prozess behandelt. Die Vorreinigung und die Hauptreinigung erfolgten in separaten Säurekreisen:
a) Vorreinigung in Beize
   20 Min Reinigen in einer Mischung aus 5 Gew.-% HF, 8 Gew.-% HCl, 3 Gew.-% H₂O₂ bei einer Temperatur von 22 °C Materialabtrag: 0,02 µm
b) Spülen mit Reinstwasser 18 MOHM für 5 Minuten bei 22 °C
c) Hauptreinigung: Ätzen 5 Min bei 8 °C
   HF/HNO₃ mit 6 Gew.-% HF, 55 Gew.-% HNO₃ und 1 Gew.-% Si Ätzabtrag: ca. 30 µm
d) 5 Min Spülen mit 22 °C warmem Reinstwasser mit 18 MOHM
e) 5 Min Hydrophilierung in 22 °C warmem Wasser, das mit 20 ppm Ozon gesättigt ist
f) 60 Min Trocknen mit Reinstluft der Klasse 100 bei 80 °C
g) Abkühlen mit Reinstluft 22 °C

Schließlich wurde der nasschemisch behandelte Stab mittels eines PE-Handschuhs in einen hochreinen PE-Beutel verpackt.

Schließlich wurde der thermisch behandelte und anschließend nasschemisch gereinigte Stab auf Verunreinigungen mit Kohlenstoff untersucht.

Dazu wurde der Stab mittels FZ zu einem einkristallinen Stab verarbeitet.

Dies führt dazu, dass alle an der Oberfläche des Stabes anhaftenden Verunreinigungen, bevorzugt Kohlenstoffverunreinigungen durch den FZ-Prozess in die Masse des entstehenden Einkristalls verteilt werden.

Die Kohlenstoffkonzentration im Silicium des FZ-gezogenen Stabs wurde mittels FTIR-Spektroskopie ermittelt.

Auch der unbehandelte Bruderstab wurde einer solchen Messung unterzogen. Hier war es jedoch nicht nötig, zunächst einen FZ-Einkristall zu erzeugen. Vom Bruderstab wurde eine Scheibe aus polykristallinem Silicium abgetrennt und der FTIR-Messung zugeführt.

Auf diese Art und Weise wurde für alle 27 Stäbe und für alle 27 Bruderstäbe die Kohlenstoffkonzentration bestimmt. Die Differenzen der Kohlenstoffmesswerte aus den Stäben und den dazugehörigen Bruderstäben ergeben dann die Werte, die den Oberflächenkohlenstoffverunreinigungen des Polysiliciums zugewiesen werden konnten.

**Tabelle 3** zeigt die ermittelten Differenzwerte für Kohlenstoffoberflächenkontaminationen.

**Tabelle 3**

| **Probe #** | **Differenz C [ppbw]** |
|---|---|
| 1 | 1,48 |
| 2 | 1,79 |
| 3 | 7,14 |
| 4 | 1,63 |
| 5 | 4,56 |
| 6 | 4,50 |
| 7 | 3,05 |
| 8 | 6,80 |
| 9 | 7,04 |
| 10 | 6,04 |
| 11 | 8,50 |
| 12 | 5,11 |
| 13 | 0,50 |
| 14 | 5,80 |
| 15 | 4,96 |
| 16 | 8,20 |
| 17 | 7,79 |
| 18 | 1,24 |
| 19 | 8,00 |
| 20 | 8,50 |
| 21 | 7,10 |
| 22 | 0,56 |
| 23 | 4,88 |
| 24 | 1,65 |
| 25 | 5,15 |
| 26 | 6,00 |
| 27 | 8,00 |

Mit Hilfe der Stab-Bruderstab-Messmethode können auch niedrige Kontaminationen, die deutlich unter 20 ppbw liegen, nachgewiesen werden. Da die hier untersuchte Bruchgröße 0 bekanntermaßen die höchste Oberflächenkontamination mit Kohlenstoff aufweist, zeigen die Ergebnisse, dass das erfindungsgemäße polykristalline Silicium für alle Bruchgrößen eine Kontamination im beanspruchten Bereich aufweist.

Weiterhin wird deutlich, dass durch einen zusätzlichen nasschemischen Reinigungsschritt die Kontamination mit Kohlenstoff an der Oberfläche stets auf weniger als 10 ppbw, zum Teil auf weniger als 5 ppbw bis auf ein Niveau von 0,5 ppbw reduziert werden kann.

## Patentansprüche

1. Polykristallines Siliciumbruchstück mit einer Konzentration von Kohlenstoff an der Oberfläche von 0,5-35 ppbw.

2. Polykristallines Siliciumbruchstück nach Anspruch 1, wobei die Konzentration von Kohlenstoff an der Oberfläche 0,5-20 ppbw beträgt.

3. Polykristallines Siliciumbruchstück nach Anspruch 2, wobei die Konzentration von Kohlenstoff an der Oberfläche 0,5-10 ppbw beträgt.

4. Verfahren zur Reinigung von polykristallinen Siliciumbruchstücken mit Kohlenstoff-Kontaminationen an der Oberfläche, umfassend eine thermische Behandlung der polykristallinen Siliciumbruchstücke in einem Reaktor bei einer Temperatur von 350 bis 600°C, wobei sich die polykristallinen Siliciumbruchstücke während der thermischen Behandlung in einer Inertgasatmosphäre befinden, wobei die polykristallinen Siliciumbruchstücke nach der thermischen Behandlung eine Konzentration von Kohlenstoff an der Oberfläche von 0,5-35 ppbw aufweisen.

5. Verfahren nach Anspruch 4, wobei die thermische Behandlung bei einem konstanten Inertgasfluss zwischen 0-250 L/min erfolgt.

6. Verfahren nach Anspruch 4 oder nach Anspruch 5, wobei das Inertgas ausgewählt wird aus der Gruppe bestehend aus Edelgase und Stickstoff.

7. Verfahren nach Anspruch 6, wobei als Inertgas Argon verwendet wird.

8. Verfahren nach einem der Ansprüche 4 bis 7, wobei die thermische Behandlung unter Ausschluss von Sauerstoff erfolgt.

9. Verfahren nach einem der Ansprüche 4 bis 8, wobei die thermische Behandlung für eine Dauer von bis zu 180 Sekunden erfolgt.

10. Verfahren nach einem der Ansprüche 4 bis 9, wobei nach der thermischen Behandlung die thermisch behandelten polykristallinen Siliciumbruchstücke aus dem Reaktor entnommen und unter Inertgasspülung auf Raumtemperatur abgekühlt werden.

## Claims

1. Chunk polycrystalline silicon having a concentration of carbon at the surface of 0.5-35 ppbw.

2. Chunk polycrystalline silicon according to Claim 1, wherein the concentration of carbon at the surface is 0.5-20 ppbw.

3. Chunk polycrystalline silicon according to Claim 2, wherein the concentration of carbon at the surface is 0.5-10 ppbw.

4. Process for cleaning polycrystalline silicon chunks having carbon contamination at the surface, comprising a thermal treatment of the polycrystalline silicon chunks in a reactor at a temperature of 350 to 600°C, the polycrystalline silicon chunks being present in an inert gas atmosphere during the thermal treatment, and the polycrystalline silicon chunks after the thermal treatment having a concentration of carbon at the surface of 0.5-35 ppbw.

5. Process according to Claim 4, wherein the thermal treatment is effected at a constant inert gas flow between 0-250 L/min.

6. Process according to Claim 4 or according to Claim 5, wherein the inert gas is selected from the group consisting of noble gases and nitrogen.

7. Process according to Claim 6, wherein the inert gas used is argon.

8. Process according to any of Claims 4 to 7, wherein the thermal treatment is effected with exclusion of oxygen.

9. Process according to any of Claims 4 to 8, wherein the thermal treatment is effected for a duration of up to 180 seconds.

10. Process according to any of Claims 4 to 9, wherein the thermal treatment is followed by withdrawal of the thermally treated polycrystalline silicon chunks from the reactor and cooling thereof to room temperature with inert gas purging.

## Revendications

1. Fragment de silicium polycristallin, présentant une concentration en carbone à la surface de 0,5-35 ppt en poids.

2. Fragment de silicium polycristallin selon la revendication 1, la concentration en carbone à la surface étant de 0,5-20 ppt en poids.

3. Fragment de silicium polycristallin selon la revendication 2, la concentration en carbone à la surface étant de 0,5-10 ppt en poids.

4. Procédé pour nettoyer des fragments de silicium polycristallin présentant des contaminations de carbone à la surface, comprenant un traitement thermique des fragments de silicium polycristallin dans un réacteur à une température de 350 à 600°C, les fragments de silicium polycristallin se trouvant, pendant le traitement thermique, dans une atmosphère de gaz inerte, les fragments de silicium polycristallin présentant, après le traitement thermique, une concentration en carbone à la surface de 0,5-35 ppt en poids.

5. Procédé selon la revendication 4, le traitement thermique étant réalisé sous un flux constant de gaz inerte entre 0-250 1/min.

6. Procédé selon la revendication 4 ou selon la revendication 5, le gaz inerte étant choisi dans le groupe constitué par les gaz nobles et l'azote.

7. Procédé selon la revendication 6, de l'argon étant utilisé comme gaz inerte.

8. Procédé selon l'une quelconque des revendications 4 à 7, le traitement thermique étant réalisé à l'abri de l'oxygène.

9. Procédé selon l'une quelconque des revendications 4 à 8, le traitement thermique étant réalisé pendant une durée allant jusqu'à 180 secondes.

10. Procédé selon l'une quelconque des revendications 4 à 9, les fragments de silicium polycristallin traités thermiquement étant prélevés du réacteur après le traitement thermique et refroidis à température ambiante sous un rinçage par un gaz inerte.
